# EUROPEAN PATENT APPLICATION

(11) **EP 4 709 069 A1**
(43) Date of publication of application: **11.03.2026**
(21) Application number: 25152240.5
(22) Date of filing: 16.01.2025
(51) Int. Cl.: H05K 7/20

(54) **AUXILIARY COOLING FOR A COOLING JACKET OF AN ECU**

(30) Priority: 06.09.2024 KR 20240121805
(71) Applicant: LG Electronics Inc., Yeongdeungpo-gu Seoul 07336 (KR)
(72) Inventor: YUN, Donghwa, 07336 Seoul (KR); KIM, Youngwook, 06772 Seoul (KR)
(74) Representative: Vossius & Partner Patentanwälte Rechtsanwälte mbB

(57) **Abstract**

An electronic control unit according to the present embodiment may comprise a cooling jacket disposed between a top case and a bottom case; a first board having a first semiconductor element mounted thereon, which is in thermal contact with a lower surface of the cooling jacket; a second board having a second semiconductor element mounted thereon, which is in thermal contact with a lower surface of the cooling jacket; a third board having a third semiconductor element mounted thereon, which is in thermal contact with each of an upper surface of the cooling jacket and the top case; a control board in thermal contact with the bottom case; and a thermoelectric element having a cooling side in thermal contact with the upper surface of the cooling jacket and a hot side in thermal contact with the top case.

## Description

The present invention relates to an electronic control unit and a method of controlling the electronic control unit.

Assemblies installed in a vehicle may comprise an engine control assembly (or motor control assembly), a power transmission assembly, a brake assembly, a suspension assembly, a steering assembly, an instrument assembly, and an information and communication control assembly.

An electronic control unit (ECU) is a control device that controls and manages the main assemblies of a vehicle. A number of electronic control units are installed in a vehicle according to the assembly and control each assembly.

The electronic control unit may comprise an electronic control unit having a chip built into it for autonomous driving or infotainment (software or media that adds entertainment to the transmission of information) installed in the vehicle, and it is desirable for such an electronic control unit to properly cool the chip or the substrate (control board) on which the chip is installed to prevent overheating of the chip.

An example of an electronic control unit that is cooled is disclosed in U.S. Patent Publication No. US 5323292 A (issued June 21, 1994) which discloses an electronic module including an aluminum heat dissipation plate surrounding an integrated circuit chip and a substrate and in which the heat dissipation plate comprises parallel fins that provide a larger surface area to dissipate heat into the surrounding atmosphere.

An object of the present invention is to provide an electronic control unit and its control method capable of efficiently and reliably dissipating heat from at least one semiconductor element even when a main cooling means does not work well, i.e. even when the main cooling means is in an abnormal state of its cooling operation.

An object of the present invention is to provide an electronic control unit and its control method, in which at least one semiconductor element may be efficiently heat-dissipated by cooling water in combination with a thermoelectric element.

An electronic control unit according to the present invention may comprise a cooling jacket disposed between a top case and a bottom case and through which cooling water can flow; at least one board having a semiconductor element mounted thereon, which is in thermal contact with an upper and/or lower surface of the cooling jacket; a control board disposed in a space formed by the top case and the bottom case; a thermoelectric element having a cooling side in thermal contact with the upper or lower surface of the cooling jacket; and a valve for closing or opening a cooling water inlet and/or a cooling water outlet of the cooling jacket. In response to an abnormal state of the cooling jacket, the valve is configured to close the cooling water inlet and/or the cooling water outlet and the thermoelectric element is configured to operate to cool the cooling jacket.

The electronic control unit may further comprise a temperature sensor configured to detect a temperature of at least one of the semiconductor element, the at least one board and the cooling jacket. The abnormal state of the cooling jacket may be determined on the basis of the detected temperature. Alternatively, the electronic control unit may comprise a sensor for measuring a flow rate of the cooling water in or into the cooling jacket. The abnormal state of the cooling jacket may be determined on the basis of the measured flow rate.

Preferably, the temperature sensor may be configured to detect the temperature of the semiconductor element.

Preferably, the abnormal state of the cooling jacket may be when the detected temperature is equal to or higher than a preset temperature.

The at least one board may comprise at least one of i) a first board having a first semiconductor element mounted thereon, which is in thermal contact with a lower surface of the cooling jacket; ii) a second board having a first semiconductor element mounted thereon, which is in thermal contact with the lower surface of the cooling jacket; and iii) a third board having a third semiconductor element mounted thereon, which is in thermal contact with the upper surface of the cooling jacket.

The control board may be disposed in thermal contact with the upper case or the bottom case.

Preferably, a hot side of the thermoelectric element may be in thermal contact with the top case, the bottom case or ambient case.

Preferably, the valve may be configured to close the cooling water inlet of the cooling jacket.

The electronic control unit may further comprise a first thermal interface material disposed between an upper surface of the first semiconductor element and the lower surface of the cooling jacket in case where the at least one board comprises the first board; a second thermal interface material disposed between an upper surface of the second semiconductor element and the lower surface of the cooling jacket in case where the at least one board comprises the second board; and/or a third thermal interface material disposed between a lower surface of the third semiconductor element and the upper surface of the cooling jacket in case where the at least one board comprises the third board.

At least one of the first semiconductor element and the second semiconductor element may comprise a system on chip.

The third semiconductor element comprises a neural network processing unit (NPU).

The first board may be connected to the control board with a first connector, and the second board may be connected to the control board with a second connector.

The third board is connected to the control board with a harness cable.

The third board may be fastened to the top case.

The control board may be fastened to the bottom case.

The top case may comprise a top body having an opening formed therein; and a heat dissipation member disposed in the opening and having heat dissipation fins formed therein.

The heat dissipation member may be in thermal contact with the hot side.

The top case may further comprise an insulation member disposed between the top body and the heat dissipation member.

The top case may further comprise a fastening member that couples the heat dissipation member, the insulation member, and the top body.

The valve and the thermoelectric element may operate in conjunction with each other according to functional failure of a water cooling loop system connected to the cooling jacket.

The electronic control unit of claim may further comprise a sub-thermoelectric element having a sub-cooling side in thermal contact with a side of the cooling jacket and a sub-hot side in thermal contact with the top case or the bottom case.

A rib with which the sub-hot side of the sub-thermoelectric element is in thermal contact may protrude from the top case.

The first semiconductor element may be closer to the thermoelectric element among the thermoelectric element and the sub-thermoelectric element.

The second semiconductor element and the third semiconductor element may be closer to the sub-thermoelectric element among the thermoelectric element and the sub-thermoelectric element.

The first semiconductor element may comprise a first temperature sensor; the second semiconductor element may comprise a second temperature sensor; and/or the third semiconductor element may comprise a third temperature sensor. In other word, the temperature sensor may comprise at least one of the first temperature sensor, the second temperature sensor and the third temperature sensor.

The electronic control unit may further comprise a micro control unit configured to control operations of the valve and the thermoelectric element in response to signals corresponding to the abnormal state of the cooling jacket.

The micro control unit may control the thermoelectric element, the sub-thermoelectric element, and the valve according to the sensing value of the temperature sensor.

The micro control unit may apply voltage to the thermoelectric element and controls the valve to a close mode in which the cooling water inlet is closed if a temperature sensed by the first temperature sensor is equal to or higher than a first set temperature.

The micro control unit may apply voltage to the sub-thermoelectric element and controls the valve to the close mode in which the cooling water inlet is closed if a temperature sensed by the second temperature sensor is equal to or higher than a second set temperature or a temperature sensed by the third temperature sensor is equal to or higher than a third set temperature.

If the temperature sensed by the first temperature sensor is lower than the first set temperature, the micro control unit may not apply voltage to the thermoelectric element and control the valve to an open mode in which the cooling water inlet is opened.

If the temperature sensed by the second temperature sensor is less than the second set temperature and the temperature sensed by the third temperature sensor is less than the third set temperature, the micro control unit may not apply voltage to the sub-thermoelectric element and control the valve to the open mode in which the cooling water inlet is opened.

The present invention also provides a method of controlling the above-identified electronic control unit, which comprising detecting an abnormal state of the cooling jacket or receiving signals from an external device indicating the abnormal state of the cooling jacket; and in response to said detecting or receiving, operating the valve to block a cooling water flow into the cooling jacket and operating the thermoelectric element to cool the cooling jacket.

According to the present invention, heat of at least one semiconductor element may be reliably and efficiently dissipated by a cooling jacket and a thermoelectric element.

In addition, since the heat of the at least one semiconductor element is dissipated through the cooling water of the cooling jacket or the top case, and the heat of the control board is dissipated through the bottom case, the heat of the at least one semiconductor element and the heat of the control board may be dissipated quickly.

In addition, since the first semiconductor element and the second semiconductor element including the system on chip are in thermal contact with the lower surface of the cooling jacket, and the third semiconductor element including the neural processing unit (NPU) is in thermal contact with the upper surface of the cooling jacket, the heat transfer between the upper and lower surfaces of the cooling jacket may be balanced, and the cooling jacket may quickly dissipate heat from all of the first semiconductor element, the second semiconductor element, and the third semiconductor element.

In addition, the first board and the second board, which are close to the control board, are connected to the control board with connectors, and the third board, which is far from the control board, is connected to the control board with a harness cable, so that the number of harness cables may be minimized.

In addition, the top case comprises a top body having an opening formed therein; and a heat dissipation member disposed in the opening and having heat dissipation fins formed therein, and further comprises an insulation member disposed between the top body and the heat dissipation member, so as to minimize heat absorbed by the thermoelectric element from being transferred to the third board, and minimize overheating of the third board.

In addition, since the fastening member couples the heat dissipation member, the insulation member, and the top body, the number of fastening members for coupling the heat dissipation member, the insulation member, and the top body may be minimized.

In addition, a plurality of areas of the cooling jacket may be quickly cooled by using a thermoelectric element whose cooling side is in thermal contact with the upper surface of the cooling jacket and a sub-thermoelectric element whose sub-cooling side is in thermal contact with the side surface of the cooling jacket.

In addition, since the first semiconductor element is closer to the thermoelectric element, and the second semiconductor element and the third semiconductor element are closer to the sub-thermoelectric element, when some of the semiconductor elements among the first semiconductor element, the second semiconductor element, and the third semiconductor element are overheated, only one of the thermoelectric element and the sub-thermoelectric element is operated, so that power consumption may be minimized.

In addition, the heat of the semiconductor elements is dissipated by the cooling water of the cooling jacket, and when at least one of the semiconductor elements is overheated, the thermoelectric element cools the cooling jacket to dissipate heat from the semiconductor element, so that the power consumption of the thermoelectric element may be minimized.

In addition, when the thermoelectric element or sub-thermoelectric element absorbs heat from the cooling jacket, the valve closes the cooling water inlet to block the cooling water from flowing into the cooling jacket, thereby minimizing efficiency degradation due to high-temperature cooling water.

### BRIEF DESCRIPTION OF THE DRAWINGS

FIG. 1 is a perspective view illustrating an example of an electronic control unit according to the present embodiment,
FIG. 2 is a view illustrating the interior of an example of an electronic control unit according to the present embodiment,
FIG. 3 is an exploded perspective view illustrating an example of an electronic control unit according to the present embodiment,
FIG. 4 is a view illustrating an example of an electronic control unit according to the present embodiment when cooled by a water-cooling loop system,
FIG. 5 is a control block diagram illustrating an example of an electronic control unit according to the present embodiment,
FIG. 6 is a flow chart illustrating an example of an electronic control unit according to the present embodiment,
Fig. 7 is a cross-sectional view illustrating another example of an electronic control unit according to the present embodiment, and
FIG. 8 is a control block diagram illustrating another example of an electronic control unit according to the present embodiment.

Hereinafter, specific embodiments of the present disclosure will be described in detail with reference to the drawings.

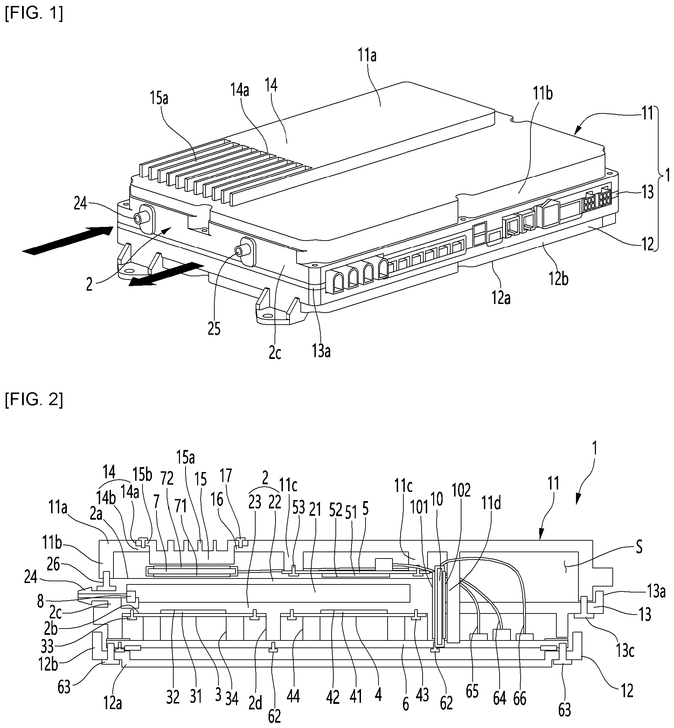

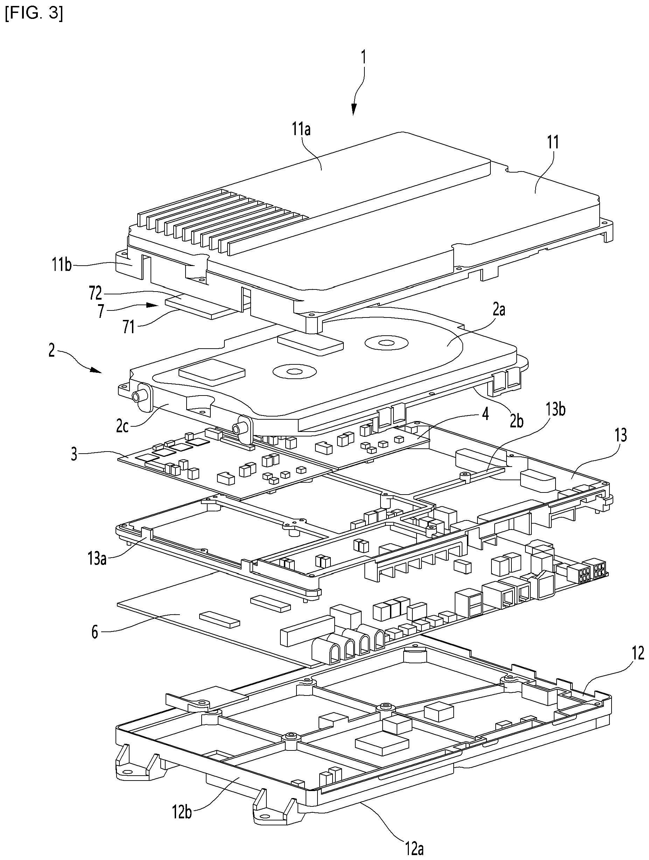

FIG. 1 is a perspective view illustrating an example of an electronic control unit according to the present embodiment, FIG. 2 is a view illustrating the interior of an example of an electronic control unit according to the present embodiment, and FIG. 3 is an exploded perspective view illustrating an example of an electronic control unit according to the present embodiment.

An electronic control unit according to the present embodiment may comprise a housing 1, a cooling jacket 2, at least one board, a control board 6, and a thermoelectric element 7. The at least one board may comprise a first board 3, a second board 4 and a third board 5.

The housing 1 may form an outer appearance of the electronic control unit.

An inner space S may be formed inside the housing 1. Various components constituting the electronic control unit may be accommodated in the inner space S.

A cooling jacket 2, a first board 3, a second board 4, a third board 5, a control board 6, a thermoelectric element 7, a sub-thermoelectric element 10, or the like may be accommodated in an inner space S and protected by a housing 1.

The housing 1 may be composed of a combination of a plurality of members.

The housing 1 may comprise a top case 11 and a bottom case 12.

The top case 11 may form an outer appearance of an upper surface of the electronic control unit. The bottom surface of the top case 11 may be open. The top case 11 may comprise an upper body 11a and a peripheral body 11b protruding from the upper body 11a.

The top case 11 may be made of aluminum and may act as a heat sink.

Heat from at least one of the first board 3, the second board 4, and the third board 5 may be transferred to the top case 11, and the top case 11 may dissipate heat transferred from at least one of the first board 3, the second board 4, and the third board 5 to the top case 11 to the outside.

The bottom case 12 may form an outer appearance of a lower surface of the electronic control unit. The upper surface of the bottom case 12 may be open. The bottom case 12 may comprise a lower body 12a and a peripheral body 12b protruding from the lower body 12a.

The bottom case 12 may be made of aluminum and may act as a heat sink.

The heat of the control board 6 may be transferred to the bottom case 12, and the bottom case 12 may dissipate the heat transferred from the control board 6 to the bottom case 12 to the outside. Alternatively, if the control board 6 is disposed between the cooling jacket 2 and the top case 11, the control board 6 may be disposed to transfer its heat to the top case 11.

An example of a housing 1 may comprise a top case 11 and a bottom case 12 and may further comprise a frame 13 positioned between the top case 11 and the bottom case 12.

The frame 13 may comprise a peripheral body 13a.

An example of a frame 13 may be a middle case positioned between a top case 11 and a bottom case 12.

An example of a perimeter body 13a of a frame 13 may be positioned between a perimeter body 11b of a top case 11 and a perimeter body 12b of a bottom case 12, or may be positioned between a perimeter body 2c of a cooling jacket 2 and a perimeter body 12b of a bottom case 12, and the perimeter body 13a may form an outer appearance of a perimeter surface of an electronic control unit.

As another example of a frame 13, the entire frame 13 may be accommodated in the inner space S.

A seating body 13b on which a cooling jacket 2 is mounted may be formed in the frame 13, and the frame 13 may support the cooling jacket 2.

The frame 13 may be fastened to the top case 11 from the lower side of the top case 11. The frame 13 may be fastened to the top case 11 by a fastening member 13c such as a screw and a hook.

Another example of the housing 1 may comprise a top case 11 and a bottom case 12 without further including a frame 13. When another example of the housing 1 comprises a top case 11 and a bottom case 12, the top case 11 and the bottom case 12 may be fastened by fastening members such as a screw and a hook.

A cooling jacket 2 may be accommodated in the inner space S.

A cooling water flow path 21 through which a cooling water, such as water, flows may be formed inside the cooling jacket 2.

The cooling jacket 2 may comprise an upper cooling plate 22 and a lower cooling plate 23 disposed below the upper cooling plate 22, and a cooling water flow path 21 may be formed between the upper cooling plate 22 and the lower cooling plate 23.

The upper surface of the upper cooling plate 22 may be the upper surface 2a of the cooling jacket 2.

The lower surface of the lower cooling plate 23 may be the lower surface 2b of the cooling jacket 2.

The upper surface 2a of the cooling jacket 2 and the lower surface 2b of the cooling jacket 2 may each be a heat absorbing surface that absorbs heat from the semiconductor element.

Either the upper surface 2a of the cooling jacket 2 or the lower surface 2b of the cooling jacket 2 may be a heat dissipation surface that transfers heat to the thermoelectric element 7.

The cooling jacket 2 may comprise a peripheral body 2c exposed to the outside.

At least one of the upper cooling plate 22 and the lower cooling plate 23 may form a peripheral body 2c of the cooling jacket 2.

A cooling water inlet 24 for guiding cooling water to a cooling water path 21 may be formed in the cooling jacket 2. The cooling water inlet 24 may be disposed to protrude on one side of the cooling jacket 2. The cooling water inlet 24 may be formed to protrude on the peripheral body 2c of the cooling jacket 2.

A cooling water outlet 25 for guiding cooling water passing through a cooling water path 21 may be formed in the cooling jacket 2. The cooling water outlet 25 may be disposed to protrude on one side of the cooling jacket 2. The cooling water outlet 25 may be formed to protrude on the peripheral body 2c of the cooling jacket 2. The cooling water outlet 25 may be formed parallel to the cooling water inlet 24.

At least one of the cooling jacket 2 and the frame 13 may be fastened to the top case 11 using a fastening member 26 such as a screw.

The first board 3, the second board 4, the third board 5, and the thermoelectric element 7 may be distributed and disposed on the upper surface 2a and the lower surface 2b of the cooling jacket 2.

For example, when the first board 3 and the second board 4 are disposed on the lower surface 2b of the cooling jacket 2, the third board 5 and the thermoelectric element 7 may be disposed on the upper surface 2a of the cooling jacket 2.

Conversely, when the first board 3 and the second board 4 are disposed on the upper surface 2a of the cooling jacket 2, the third board 5 and the thermoelectric element 7 may be disposed on the lower surface 2b of the cooling jacket 2.

A first semiconductor element 31 may be mounted on the first board 3. The first semiconductor element 31 may be mounted on the upper surface of the first board 3.

The first semiconductor element 31 may be in thermal contact with the lower surface 2b of the cooling jacket 2, and the heat of the first semiconductor element 31 may be transferred to the lower surface 2b of the cooling jacket 2.

An example of the first semiconductor element 31 may be a system on chip (SoC) mounted on the first board 3.

An example of the first semiconductor element 31 may be a semiconductor chip that performs autonomous driving of a vehicle.

The electronic control unit may comprise a first thermal interface material 32.

A first thermal interface material 32 may be disposed between the upper surface of the first semiconductor element 31 and the lower surface 2b of the cooling jacket 2. Examples of the first thermal interface material 32 may be a thermal pad or a thermal tape.

The first board 3 may be fastened to the cooling jacket 2 or the frame 13. The first board 3 may be fastened to the cooling jacket 2 or the frame 13 using a fastening member such as a screw.

The first board 3 may be fastened to the cooling jacket 2 or frame 13 using a fastening member 33 such as a screw from the lower side of the cooling jacket 2.

The first board 3 may be connected to the control board 6 with a connector. An example of the connector may be a B2B connector having a female and a male.

The first board 3 may be connected to the control board 6 and the first connector 34.

A second semiconductor element 41 may be mounted on the second board 4. The second semiconductor element 41 may be mounted on the upper surface of the second board 4.

The second semiconductor element 41 may be in thermal contact with the lower surface 2b of the cooling jacket 2, and the heat of the second semiconductor element 41 may be transferred to the lower surface 2b of the cooling jacket 2.

The second semiconductor element 41 may be parallel to the first semiconductor element 31. The first semiconductor element 31 and the second semiconductor element 41 may be spaced apart in the horizontal direction.

Each of the first semiconductor element 31 and the second semiconductor element 41 may be in thermal contact with the lower surface 2b of the cooling jacket 2 and may be cooled by the cooling jacket 2.

The lower surface 2b of the cooling jacket 2 may be a heat absorbing surface that absorbs the heat of the first semiconductor element 31 and the heat of the second semiconductor element 41.

The second board 4 may be parallel to the first board 3. The second board 4 may be spaced horizontally from the first board 3.

An example of the second semiconductor element 41 may be a system on chip (SoC) mounted on the second board 4.

An example of the second semiconductor element 41 may be a semiconductor chip that performs autonomous driving of a vehicle.

The first semiconductor element 31 and the second semiconductor element 41 are CPUs of the same specifications, and are divided into a primary node and a secondary node to perform the same function, and even if a hardware failure occurs in one node, they may back up each other to ensure that normal function is performed.

The electronic control unit may comprise a second thermal interface material 42.

A second thermal interface material 42 may be disposed between the upper surface of the second semiconductor element 41 and the lower surface 2b of the cooling jacket 2. Examples of the second thermal interface material 42 may be a thermal pad or a thermal tape.

The second board 4 may be fastened to the cooling jacket 2 or the frame 13. The second board 4 may be fastened to the cooling jacket 2 or the frame 13 using a fastening member such as a screw.

The second board 4 may be fastened to the cooling jacket 2 or frame 13 using a fastening member 43 such as a screw from the lower side of the cooling jacket 2.

The second board 4 may be connected to the control board 6 with a connector. An example of the connector may be a B2B connector having a female and a male.

The second board 4 may be connected to the control board 6 with the second connector 44.

A third semiconductor element 51 may be mounted on the third board 5. The third semiconductor element 51 may be mounted on the lower surface of the third board 5.

The third semiconductor element 51 may be in thermal contact with the upper surface 2a of the cooling jacket 2, and the heat of the third semiconductor element 51 may be transferred to the upper surface 2a of the cooling jacket 2.

An example of a third semiconductor element 51 may be a system on chip (SoC) mounted on a third board 5.

An example of the third semiconductor element 51 may be a semiconductor chip that performs autonomous driving of a vehicle.

An example of the third semiconductor element 51 may be a neural network processing unit (NPU).

When the third semiconductor element 51 is a neural network processing unit (NPU), the heating value of the third semiconductor element 51 during operation of the third semiconductor element 51 may be large, and it is desirable to balance the heat transfer between the upper surface 2a and the lower surface 2b of the cooling jacket 2.

The heating value of the first semiconductor element 31 and the heating value of the second semiconductor element 41 may be relatively smaller than the heating value of the neural network processing unit (NPU).

When the first semiconductor element 31 and the second semiconductor element 41 are in thermal contact with the lower surface 2b of the cooling jacket 2, the third semiconductor element 51 may be in thermal contact with the upper surface 2a of the cooling jacket 2.

Conversely, when the first semiconductor element 31 and the second semiconductor element 32 are in thermal contact with the upper surface 2a of the cooling jacket 2, the third semiconductor element 51 may be in thermal contact with the lower surface 2b of the cooling jacket 2.

The third semiconductor element 51 may be spaced apart from the first semiconductor element 31 or the second semiconductor element 41 with a cooling jacket 2 therebetween.

The third semiconductor element 51 may be spaced apart from one of the first semiconductor element 31 and the second semiconductor element 41 in the vertical direction. Hereinafter, the third semiconductor element 51 is described as being spaced apart from the second semiconductor element 41 in the vertical direction.

The upper surface 2a of the cooling jacket 2 may be a heat absorbing surface that absorbs heat from the third semiconductor element 51.

The third semiconductor element 51 may be biased horizontally on the upper surface 2a of the cooling jacket 2.

The electronic control unit may further comprise a third thermal interface material 52.

A third thermal interface material 52 may be disposed between the lower surface of the third semiconductor element 51 and the upper surface 2a of the cooling jacket 2. Examples of the third thermal interface material 52 may be a thermal pad or a thermal tape.

The third board 5 may be fastened to the top case 11. The third board 5 may be fastened to the top case 11 with a fastening member 53 such as a screw. A third board fastening part 11c protruding downward may be formed in the top case 11, and the fastening member 53 such as a screw may be fastened to the third board fastening part 11c. An example of the third board fastening part 11c may be a fastening boss to which a screw or the like is fastened.

The control board 6 may be equipped with a micro control unit (MCU) 61. This control unit 61 may control the overall operation of the electronic control unit. The control board 6 may be a back plane board.

The control board 6 may be in thermal contact with the cooling jacket 2.

The control board 6 may be fastened to a control board fastening part 2d formed on a cooling jacket 2 or frame 13 with a fastening member 62 such as a screw.

The control board 6 may be in thermal contact with the bottom case 12.

The control board 6 may be fastened to the bottom case 12.

The control board 6 may be fastened to the bottom case 12 with a fastening member 63 such as a screw.

The upper surface of the control board 6 may face the lower surface of the first board 3 and the lower surface of the second board 4, respectively.

The control board 6 may be spaced apart from the first board 3 in the vertical direction.

The control board 6 may be connected to the first board 3 with the first connector 34.

The control board 6 may be spaced apart from the second board 4 in the vertical direction.

The control board 6 may be connected to the second board 4 with the second connector 44.

The control board 6 may be connected to the third board 5 with a harness cable 64. The harness cable 64 connecting the control board 6 and the third board 5 may be the first harness cable.

The control board 6 may be connected to the thermoelectric element 7 with a harness cable 65. The harness cable 65 connecting the control board 6 and the thermoelectric element 7 may be a second harness cable.

The control board 6 may be connected to the sub-thermoelectric element 10 with a harness cable 66. The harness cable 66 connecting the control board 6 and the sub-thermoelectric element 10 may be a third harness cable.

The thermoelectric element 7 may comprise a cooling side 71 and a hot side 72.

The cooling side 71 may be in thermal contact with the upper surface 2a of the cooling jacket 2.

The thermoelectric element 7 may contact the upper surface 2a of the cooling jacket 2 in the same way as the third semiconductor element 51 in order to preferentially cool the third semiconductor element 51 with a large heating value.

The hot side 72 may be in thermal contact with the top case 11, as depicted in figure 2. However, if the thermoelectric element 7 is disposed to contact the lower surface of the cooling jacket 2, the hot side 72 may be in thermal contact with the bottom case 12. Alternatively, a portion of the top case 11 or the bottom case 12 facing the hot side 72 may have an opening such that the hot side 72 may be exposed to ambient air.

The upper surface 2a of the cooling jacket 2 may be a heat dissipation surface that dissipates heat to a thermoelectric element 7.

The upper surface 2a of the cooling jacket 2 may be a heat absorption and heat dissipation surface that absorbs heat from the third semiconductor element 51 and also dissipates heat to the thermoelectric element 7.

The thermoelectric element 7 may be operated by at least one of the temperature of the first semiconductor element 31, the temperature of the second semiconductor element 41, or the temperature of the third semiconductor element 51.

The thermoelectric element 7 may be disposed on the upper side of the cooling jacket 2 and may be parallel to the third board 5.

The thermoelectric element 7 may be biased horizontally on the upper surface 2a of the cooling jacket 2.

The thermoelectric element 7 may be spaced horizontally from the third board 5.

The thermoelectric element 7 may be spaced apart vertically from one of the first board 3 and the second board 4. Hereinafter, the thermoelectric element 7 is described as being spaced apart vertically from the first board 3 with the cooling jacket 2 interposed therebetween.

Heat from the hot side 72 may be transferred to the top case 11, and the top case 11 may dissipate the heat transferred from the hot side 72 to the outside.

The top case 11 may be composed of a single member, or may be composed of a combination of a plurality of members.

It is desirable that the heat transferred from the hot side 72 to the top case 11 is not transferred to the third board 5 as much as possible, and it is desirable that the top case 11 be thermally insulated from the part where the hot side 72 comes into contact and the part where the third board 5 comes into contact.

The top case 11 may comprise a top body 14 including a portion that is in contact with the third board 5, a heat dissipation member 15 including a portion that is in contact with the hot side 72, and may further comprise an insulation member 16 that is disposed between the heat dissipation member 15 and the top body 14 to block heat.

The top case 11 may comprise a top body 14 having an opening 14a formed therein; and a heat dissipation member 15 disposed in the opening 14a and having a heat dissipation fin 15a formed therein.

The top body 14 may comprise an upper body 11a and a peripheral body 11b protruding from the upper body 11a.

The top body 14 may be formed with a seating part 14b on which an insulation member 16 may be seated.

The heat dissipation member 15 may comprise a heat sink having at least one heat dissipation fin 15a formed thereon. The heat dissipation fin 15a may be formed on a surface of the heat dissipation member 15 that is exposed to the outside. A plurality of heat dissipation fins 15a may be formed, and the plurality of heat dissipation fins 15a may be parallel to each other.

The heat dissipation member 15 may be in thermal contact with the hot side 72 of the thermoelectric element 7.

The heat dissipation member 15 may be formed with a fastening part 15b that is fastened to the top body 14.

The top case 11 may further comprise an insulation member 16. The insulation member 16 may be disposed between the top body 14 and the heat dissipation member 15, and may block heat from the heat dissipation member 15 from being transferred to the top body 14.

Heat transferred from the thermoelectric element 7 to the heat dissipation member 15 may be minimized from being transferred to the top body 14 by being blocked by the insulation member 16, and may be dissipated to the outside through the heat dissipation fin 15a.

The electronic control unit may further comprise a heat dissipation member 15, an insulation member 16, and a fastening member 17 that couples the top body 14.

The fastening member 17 may sequentially penetrate the fastening member 15b, the insulation member 16, and the fixing member 14a, and may couple the heat dissipation member 15, the insulation member 16, and the top body 14.

The electronic control unit may further comprise a valve 8 disposed in the cooling water inlet 24 and/or the cooling water outlet 25 of the cooling jacket 2, preferably in the cooling water inlet 24.

An example of the valve 8 may be an electric valve and may comprise a motor. An example of the valve 8 may be a motorized valve.

The valve 8 may be controlled in open or closed mode by a micro control unit 61.

In the open mode of the valve 8, the valve 8 may be opened to open the cooling water inlet 24, and cooling water may flow into the cooling water flow path 21.

In the closed mode of the valve 8, the valve 8 may be closed to block the cooling water inlet 24, and cooling water cannot flow into the cooling water flow path 21.

The valve 8 may receive a signal from the micro control unit 61 and actively control the flow rate so that the junction temperature, which varies according to the operating rate of the semiconductor element, does not exceed the allowable temperature (Max Tj) of the semiconductor element. Here, the junction temperature may be defined as the highest temperature of the semiconductor element and may be the temperature output from a temperature sensor installed in the semiconductor element.

In particular, the micro control unit 61 may control, in response to an abnormal state of the cooling jacket 2, the valve 8 and the thermoelectric element 7. The abnormal state of the cooling jacket 2 can be determined on the basis of sensing data detected by a sensor within the electronic control unit, or on the basis of data (signals) received from an external device indicating such abnormal state of the cooling jacket 2. This sensor within the electronic control unit may be a temperature sensor for sensing a temperature of at least one of the semiconductor element, the at least one board and the cooling jacket 2. Alternatively, a sensor for sensing a flow rate of cooling water into the cooling jacket 2 may be used to determine an abnormal state of the cooling jacket 2.

The thermoelectric element 7 and valve 8 may be selectively operated.

When the valve 8 is in the open mode, the thermoelectric element 7 may be turned off, and the heat of the first semiconductor element 31, the heat of the second semiconductor element 41, and the heat of the third semiconductor element 51 may be dissipated to the cooling water flowing through the cooling water flow path 21 and may be dissipated in a water-cooled manner.

When the valve 8 is in the closed mode, the thermoelectric element 7 may be turned on, and the heat of the first semiconductor element 31, the heat of the second semiconductor element 41, and the heat of the third semiconductor element 51 may be transferred to the top case 11 by the thermoelectric element 7 and may be dissipated by air cooling.

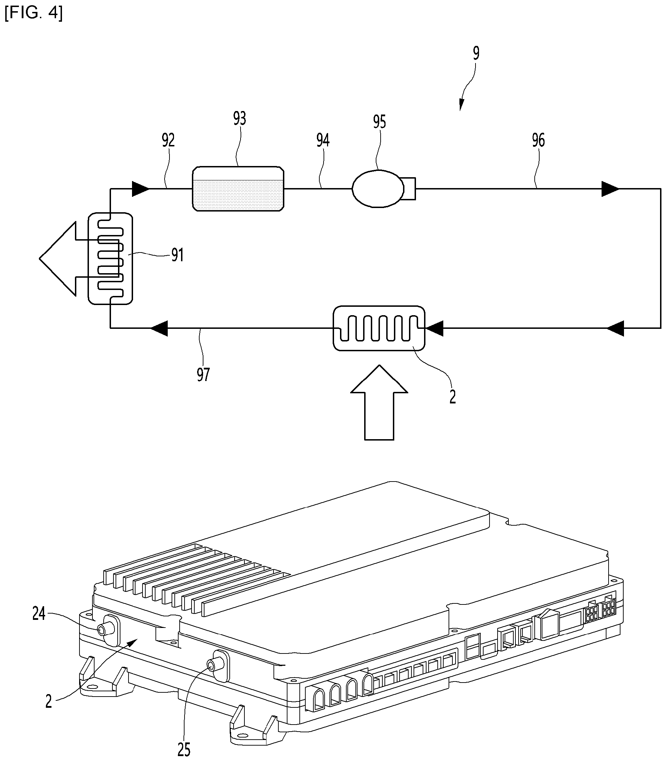

The thermoelectric element 7 and the valve 8 may operate in conjunction with each other according to the functional failure (i.e. abnormal state) of the water-cooling loop system 9 (see Fig. 4) connected to the cooling jacket 2. The water-cooling loop system 9 will be described later with reference to Fig. 4.

The electronic control unit may further comprise a sub-thermoelectric element 10.

The sub-thermoelectric element 10 may comprise a sub-cooling side 101 and a sub-hot side 102.

The sub-thermoelectric elements 10 may be disposed in the vertical direction.

The sub-cooling side 101 may be in thermal contact with the side of the cooling jacket 2.

The sub-cooling side 101 may be in thermal contact with the peripheral body 2c of the cooling jacket 2.

The sub-cooling side 101 may be in contact with one of the four peripheral bodies 2c of the cooling jacket 2.

The sub-hot side 102 may be in thermal contact with the top case 11.

The side of the cooling jacket 2 may be a heat dissipation surface that transfers heat to the sub-thermoelectric element 10.

The sub-thermoelectric element 10 may be operated by at least one of the temperature of the first semiconductor element 31, the temperature of the second semiconductor element 41, or the temperature of the third semiconductor element 51.

A rib 11d may be protruded from the top case 11 to thermally contact the sub-hot side 102 of the sub-thermoelectric element 10. A rib 11c may be protruded from the top body 14.

The first semiconductor element 31 may be closer to the thermoelectric element 7 among the thermoelectric element 7 and the sub-thermoelectric element 10.

The second semiconductor element 41 and the third semiconductor element 51 may be closer to the sub-thermoelectric element 10 among the thermoelectric element 7 and the sub-thermoelectric element 10.

When the heat of the first semiconductor element 31 is excessive, the thermoelectric element 7 may be turned on, and when the heat of the second semiconductor element 41 or the heat of the third semiconductor element 51 is excessive, the sub-thermoelectric element 10 may be turned on.

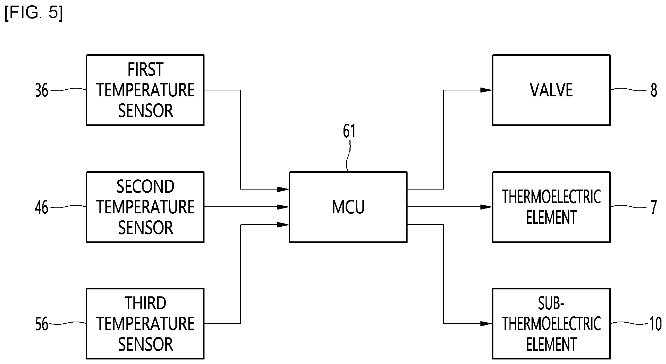

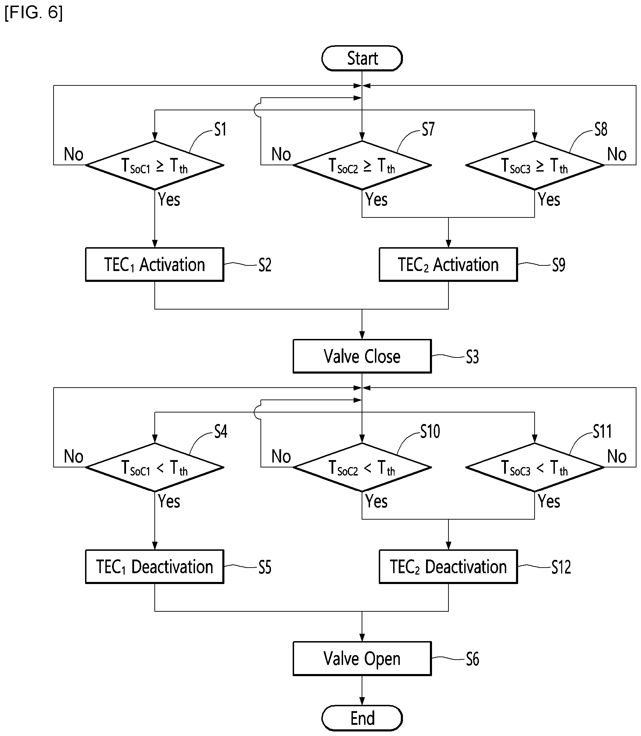

FIG. 4 is a view illustrating an example of an electronic control unit according to the present embodiment when cooled by a water-cooling loop system, FIG. 5 is a control block diagram illustrating an example of an electronic control unit according to the present embodiment, and FIG. 6 is a flow chart illustrating an example of an electronic control unit according to the present embodiment.

The water-cooling loop system 9 may comprise a heat exchanger 91, a cooling water tank 93 connected to the heat exchanger 91 through a heat exchanger outlet pipe 92, a pump 95 connected to the cooling water tank 93 through a pump inlet pipe 94, and a pump outlet pipe 96 connecting the pump 95 and an electronic control unit, and the electronic control unit and the heat exchanger 91 may be connected through a heat exchanger inlet pipe 97.

The heat exchanger 91 may dissipate the heat of the cooling water to the atmosphere in an air-cooled manner. An example of the heat exchanger 91 may be a radiator.

The pump outlet pipe 96 may be connected to the cooling water inlet 24 of the cooling jacket 2.

The heat exchanger inlet pipe 97 may be connected to the cooling water outlet 25 of the cooling jacket 2.

Cooling water may circulate through the heat exchanger 91 and the cooling jacket 2 and dissipate heat to the electronic control unit.

The water-cooling loop system 9 may comprise a temperature sensor, a flow sensor or a flow rate sensor.

The water-cooling loop system 9 may control the valve 8 to a closed mode that closes the cooling water inlet 24 according to the sensing value of the temperature sensor, the flow sensor, or the flow rate sensor.

The water-cooled loop system 9 may have no flow of cooling water due to a failure of the pump 95, and the flow amount may be 0 m³/hr or the flow rate may be 0 m/s.

The water-cooled loop system 9 may experience an increase in cooling water temperature due to a failure of the heat exchanger 91.

When normal cooling water flows into the cooling water inlet 24 of the cooling jacket 2 and normal cooling water flows out of the cooling water outlet 25 of the cooling jacket 2, the junction temperature of the first semiconductor element 31, the junction temperature of the second semiconductor element 41, and the junction temperature of the third semiconductor element 51 may be within normal ranges.

However, if normal cooling water does not flow into the cooling water inlet 24 of the cooling jacket 2 due to a failure of the heat exchanger 91 or pump 95, the temperature of the semiconductor element may rapidly increase, the temperature of the semiconductor element may reach a limit temperature, and the semiconductor element may be thermally shut down.

Each of the first semiconductor element 31, the second semiconductor element 41, and the third semiconductor element 51 may comprise a temperature sensor.

The first semiconductor element 31 may comprise a first temperature sensor 36, the second semiconductor element 41 may comprise a second temperature sensor 46, and the third semiconductor element 51 may comprise a third temperature sensor 56.

The first temperature sensor 36 may be provided inside the first semiconductor element 31 and may measure the junction temperature of the first semiconductor element 31.

A second temperature sensor 46 may be provided inside the second semiconductor element 41 and may measure the junction temperature of the second semiconductor element 41.

The third temperature sensor 56 may be provided inside the third semiconductor element 51 and may measure the junction temperature of the third semiconductor element 51.

The electronic control unit may further comprise a micro control unit 61.

The micro control unit 61 may compare the temperature input from the temperature sensor with the set temperature in real time, and if the temperature input from the temperature sensor is higher than the set temperature, may execute logic for driving the thermoelectric element 7 and the sub-thermoelectric element 10. The micro control unit 61 may PWM control at least one of the thermoelectric element 7 and the sub-thermoelectric element 10, and may apply voltage so that at least one of the thermoelectric element 7 and the sub-thermoelectric element 10 has an appropriate heat absorption amount, and the thermal shut down of the semiconductor element may be minimized.

In addition, when the micro control unit 61 executes logic to drive at least one of the thermoelectric element 7 or the sub-thermoelectric element 10, the valve 8 may block the cooling water inlet 24, thereby preventing high-temperature cooling water from flowing into the cooling jacket 2 due to a failure of the heat exchanger 91.

The micro control unit 61 may control the thermoelectric element 7, the valve 8, and the sub-thermoelectric element 10 according to the sensing values of the first temperature sensor 36, the sensing values of the second temperature sensor 46, and the sensing values of the third temperature sensor 56.

The micro control unit 61 may control the valve 8 to a closed mode that closes the cooling water inlet by applying voltage to the thermoelectric element (7, TEC1) when the temperature (Tsoc1) sensed by the first temperature sensor 36 is equal to or higher than the first set temperature (Tth). (S1)(S2)(S3)

The first set temperature (Tth) may be a temperature set lower than the critical temperature of the first semiconductor element 31. For example, when the critical temperature of the first semiconductor element 31 is 125°C, the first set temperature (Tth) may be 120 °C or 110 °C.

When voltage is applied to the thermoelectric element 7, the thermoelectric element 7 (TEC1) may be activated. (S2)

When the valve 8 is controlled in the closed mode, the valve 8 may be closed to prevent cooling water from flowing into the cooling water inlet 24. (S3)

When the thermoelectric element 7 is turned on, the heat of the first semiconductor element 31 may be transferred to the cooling side 71 of the thermoelectric element 7 through the cooling jacket 2, and the heat of the hot side 72 of the thermoelectric element 7 may be conducted to the heat dissipation member 15 and transferred to the atmosphere through the heat dissipation fin 15a to be dissipated by air cooling.

In the closed mode of the valve 8, the cooling water whose temperature has increased due to a failure of the heat exchanger 91 may no longer flow into the cooling water path 21 of the cooling jacket 2, and may not interfere with the heat dissipation of the first semiconductor element 31 by the thermoelectric element 7.

The micro control unit 61 may be controlled to open mode to open the cooling water inlet 24 without applying voltage to the thermoelectric element 7 if the temperature (Tsoc1) sensed by the first temperature sensor 36 is lower than the first set temperature (Tth). (S4)(S5)(S6)

When no voltage is applied to the thermoelectric element 7, the thermoelectric element 7 (TEC1) may be deactivated. (S5)

When the valve 8 is controlled in open mode, the valve 8 may be opened to allow cooling water to flow into the cooling water inlet 24. (S6)

The micro control unit 61 may apply voltage to sub-thermoelectric element 10 (TEC2) and control the valve 8 to the closed mode to close the cooling water inlet when the temperature (Tsoc2) sensed by the second temperature sensor 46 is equal to or higher than the second set temperature (Tth) or the temperature (Tsoc3) sensed by the third temperature sensor 56 is equal to or higher than the third set temperature (Tth). (S7)(S8)(S9)(S3)

The second set temperature (Tth) may be a temperature set lower than the critical temperature of the second semiconductor element 41. For example, when the critical temperature of the second semiconductor element 41 is 125 °C, the second set temperature (Tth) may be 120 °C or 110 °C.

The second set temperature (Tth) may be set to be the same as or different from the first set temperature.

The third set temperature (Tth) may be a temperature set lower than the critical temperature of the third semiconductor element 51. For example, when the critical temperature of the third semiconductor element 51 is 125 °C, the third set temperature (Tth) may be 120 °C or 110 °C.

The third set temperature (Tth) may be set to be the same as or different from the first set temperature.

When voltage is applied to the sub-thermoelectric element 10, the sub-thermoelectric element 10 (TEC2) may be activated. (S9)

When the valve 8 is controlled in the closed mode, the valve 8 may be closed to prevent cooling water from flowing into the cooling water inlet 24. (S3)

When the sub-thermoelectric element 10 is turned on, the heat of the second semiconductor element 41 or the heat of the third semiconductor element 51 may be transferred to the sub-cooling side 101 through the cooling jacket 2, and the heat of the sub-hot side 102 of the sub-thermoelectric element 10 may be transferred to the top body 14 and may be dissipated by air cooling.

In the closed mode of the valve 8, the cooling water whose temperature has increased due to a failure of the heat exchanger 91 may no longer flow into the cooling water path 21 of the cooling jacket 2, and may not interfere with the heat dissipation of the second semiconductor element 41 and the heat dissipation of the third semiconductor element 51 by the sub-thermoelectric element 10.

The micro control unit 61 may not apply voltage to the sub-thermoelectric element 10 (TEC2) and the valve 8 may be controlled in open mode to open the cooling water inlet when the temperature (Tsoc2) sensed by the second temperature sensor 46 is lower than the second set temperature (Tth) and the temperature (Tsoc2) sensed by the third temperature sensor 56 is lower than the third set temperature (Tth). (S10)(S11)(S12)(S6)

When no voltage is applied to the sub-thermoelectric element 10, the sub-thermoelectric element 10 (TEC2) may be deactivated. (S12)

When the valve 8 is controlled in open mode, the valve 8 may be opened to allow cooling water to flow into the cooling water inlet 24. (S6)

As an example of an electronic control unit, according to the sensing value of a temperature sensor, a flow sensor, or a flow rate sensor of a water-cooling loop system 9, a device that applies voltage to a thermoelectric element 7 or a sub-thermoelectric element 10 and controls the valve 8 in a closed mode to close the cooling water inlet 24 is also possible.

As an example of an electronic control unit, if the temperature sensed by the temperature sensor is equal to or higher than the set temperature, a device that applies voltage to a thermoelectric element 7 or a sub-thermoelectric element 10 and controls the valve 8 in a closed mode that closes the cooling water inlet 24 is also possible.

As an example of an electronic control unit, if the flow rate sensed by the flow sensor is equal to or lower than the set flow rate, a device that applies voltage to a thermoelectric element 7 or a sub-thermoelectric element 10 and controls the valve 8 in a closed mode that closes the cooling water inlet 24 is also possible.

As an example of an electronic control unit, if the flow rate sensed by the flow rate sensor is equal to or lower than the set flow rate, a device that applies voltage to a thermoelectric element 7 or a sub-thermoelectric element 10 and controls the valve 8 in a closed mode that closes the cooling water inlet 24 is also possible.

As an example of an electronic control unit, a device that applies voltage to a sub-thermoelectric element 10 is also possible while applying voltage to a thermoelectric element 7.

As an example of an electronic control unit, a device that applies voltage to a thermoelectric element 7 or a sub-thermoelectric element 10 while the valve 8 is in open mode is also possible, and as an example of a thermoelectric element 7 or a sub-thermoelectric element 10, a device that improves the heat dissipation performance of the cooling jacket 2 is also possible.

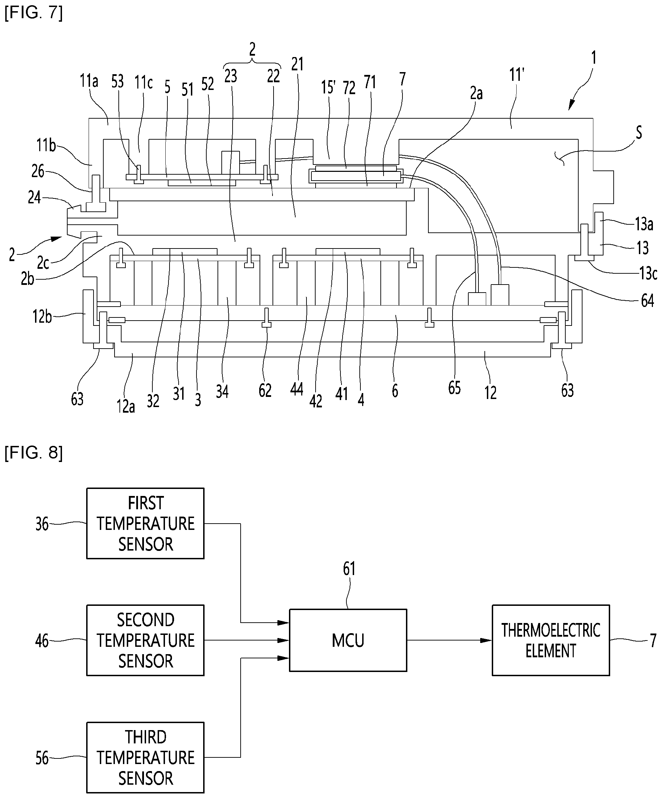

Fig. 7 is a cross-sectional view illustrating another example of an electronic control unit according to the present embodiment, and FIG. 8 is a control block diagram illustrating another example of an electronic control unit according to the present embodiment.

Another example of an electronic control unit may comprise a housing 1, a cooling jacket 2, a first board 3 having a first semiconductor element 31 mounted thereon, a second board 4 having a second semiconductor element 41 mounted thereon, a third board 5 having a third semiconductor element 51 mounted thereon, a control board 6, and a thermoelectric element 7.

Another example of an electronic control unit may dissipate heat from a cooling jacket 2 by one thermoelectric element 7, and dissipate heat from a first semiconductor element 31, a second semiconductor element 41, and a third semiconductor element 51 by one thermoelectric element 7.

The housing 1 may comprise a top case 11', a bottom case 12, and a frame 13.

The top case 11' may be different from the top case 11 of the electronic control unit. The top case 11' may comprise a contact body 15' that is in thermal contact with the hot side 72 of the thermoelectric element 7.

The bottom case 12 may be identical or similar to the bottom case 12 of the electronic control unit, and the same symbols are used for the same configuration and a detailed description thereof is omitted.

The frame 13 may be identical or similar to the frame 13 of the electronic control unit, and the same symbols are used for the same configuration and a detailed description thereof is omitted.

The first semiconductor element 31 may be identical or similar to the first semiconductor element 31 of the electronic control unit, and the same symbols are used for the same configuration and a detailed description thereof is omitted.

The first semiconductor element 31 may comprise a first temperature sensor 36.

The first board 3 may be identical or similar to the first board 3 of the electronic control unit, and the same symbols are used for the same configuration and a detailed description thereof is omitted.

The second semiconductor element 41 may be identical or similar to the second semiconductor element 41 of the electronic control unit, and the same symbols are used for the same configuration and a detailed description thereof is omitted.

The second semiconductor element 41 may comprise a second temperature sensor 46.

The second board 4 may be identical or similar to the second board 4 of the electronic control unit, and the same symbols are used for the same configuration and a detailed description thereof is omitted.

The third semiconductor element 51 may be identical or similar to the third semiconductor element 51 of the electronic control unit, and the same symbols are used for the same configuration and a detailed description thereof is omitted.

The third semiconductor element 51 may comprise a third temperature sensor 56.

The third board 5 may be identical or similar to the third board 5 of the electronic control unit, and the same symbols are used for the same configuration and a detailed description thereof is omitted.

The control board 6 may be identical or similar to the control board 6 of the electronic control unit, and the same symbols are used for the same configuration and a detailed description thereof is omitted.

The thermoelectric element 7 may comprise a cooling side 71 and a hot side 72. The thermoelectric element 7 may be identical or similar to the thermoelectric element 7 of electronic control unit, and the same symbols are used for the same configuration and a detailed description thereof is omitted.

Another example of an electronic control unit may further comprise a micro control unit 61.

The micro control unit 61 may control the thermoelectric element 7 according to the sensing value of the first temperature sensor 36, the sensing value of the second temperature sensor 46, and the sensing value of the third temperature sensor 56.

The micro control unit 61 may apply voltage to the thermoelectric element 7 if the temperature sensed by the first temperature sensor 36 is equal to or higher than the first set temperature, the temperature sensed by the second temperature sensor 46 is equal to or higher than the second set temperature, or the temperature sensed by the third temperature sensor 56 is equal to or higher than the third set temperature.

The micro control unit 61 may not apply voltage to the thermoelectric element if the temperature sensed by the first temperature sensor 36 is less than the first set temperature, the temperature sensed by the second temperature sensor 46 is less than the second set temperature, and the temperature sensed by the third temperature sensor 56 is less than the third set temperature.

For the same configuration as an example of an electronic control unit, the same symbols are used, and a detailed description thereof is omitted to avoid duplicate explanation.

The above description is merely an illustrative explanation of the technical idea of the present disclosure, and various modifications and variations will be possible to those skilled in the art without departing from the essential characteristics of the present disclosure.

Accordingly, the embodiments disclosed in the present disclosure are not intended to limit the technical idea of the present disclosure, but are for illustrative purposes, and the scope of the technical idea of the present disclosure is not limited by these embodiments.

The scope of protection of the present disclosure should be interpreted in accordance with the claims below, and all technical ideas within the equivalent scope should be interpreted as being comprised in the scope of rights of the present disclosure.

## Claims

1. An electronic control unit comprising:
a cooling jacket (2) disposed between a top case (11) and a bottom case (12), and through which cooling water can flow;
at least one board (3, 4, 5) having a semiconductor element (31, 41, 51) mounted thereon, which is in thermal contact with an upper and/or lower surface of the cooling jacket (2);
a control board (6) disposed in a space formed by the top case (11) and the bottom case (12);
a thermoelectric element (7) having a cooling side (71) in thermal contact with the upper or lower surface of the cooling jacket (2);
a valve (8) for closing or opening a cooling water inlet (24) and/or a cooling water outlet (25) of the cooling jacket (2),
wherein, in response to an abnormal state of the cooling jacket (2), the valve (8) is configured to close the cooling water inlet (24) and/or the cooling water outlet (25) and the thermoelectric element (7) is configured to operate to cool the cooling jacket (2).

2. The electronic control unit of claim 1, further comprising a temperature sensor configured to detect a temperature of at least one of the semiconductor element (31, 41, 51), the at least one board (3, 4, 5) and the cooling jacket (2),
wherein the abnormal state of the cooling jacket (2) is determined on the basis of the detected temperature, and
wherein, preferably, the temperature sensor is configured to detect the temperature of the semiconductor element (31, 41, 51), and the abnormal state of the cooling jacket (2) is when the detected temperature is equal to or higher than a preset temperature.

3. The electronic control unit of claim 1 or 2, wherein the at least one board (3, 4, 5) comprises at least one of i) a first board (3) having a first semiconductor element (31) mounted thereon, which is in thermal contact with a lower surface of the cooling jacket (2); ii) a second board (4) having a first semiconductor element (41) mounted thereon, which is in thermal contact with the lower surface of the cooling jacket (2); and iii) a third board (5) having a third semiconductor element (51) mounted thereon, which is in thermal contact with the upper surface of the cooling jacket (2).

4. The electronic control unit of any one of claims 1 to 3, wherein the control board (6) is disposed in thermal contact with the upper case (11) or the bottom case (12).

5. The electronic control unit of any one of claims 1 to 4, wherein a hot side (72) of the thermoelectric element (7) is in thermal contact with the top case (11), the bottom case (12) or ambient case.

6. The electronic control unit of any one of claims 1 to 5, wherein the valve (8) is configured to close the cooling water inlet (24) of the cooling jacket (2).

7. The electronic control unit of any one of claims 1 to 6, insofar as depending on claim 3, further comprising:
a first thermal interface material (32) disposed between an upper surface of the first semiconductor element (31) and the lower surface of the cooling jacket (2) in case where the at least one board (3, 4, 5) comprises the first board (3);
a second thermal interface material (42) disposed between an upper surface of the second semiconductor element (41) and the lower surface of the cooling jacket (2) in case where the at least one board (3, 4, 5) comprises the second board (4); and/or
a third thermal interface material (52) disposed between a lower surface of the third semiconductor element (51) and the upper surface of the cooling jacket (2) in case where the at least one board (3, 4, 5) comprises the third board (5).

8. The electronic control unit of any one of claims 1 to 7,
wherein the top case (11) comprises:
a top body (14) having an opening (14a) formed therein; and
a heat dissipation member (15) disposed in the opening (15a) and having heat dissipation fins (15a) formed therein.

9. The electronic control unit of claim 8,
wherein the heat dissipation member (15) is in thermal contact with the hot side (72).

10. The electronic control unit of claim 8 or 9,
wherein the top case (11) further comprises an insulation member (16) disposed between the top body (14) and the heat dissipation member (15).

11. The electronic control unit of claim 10,
wherein the top case (11) further comprises a fastening member (17) that couples the heat dissipation member (15), the insulation member (16), and the top body (14).

12. The electronic control unit of any one of claims 1 to 11, further comprising:
a sub-thermoelectric element (10) having a sub-cooling side (101) in thermal contact with a side of the cooling jacket (2) and a sub-hot side (102) in thermal contact with the top case (11) or the bottom case (12).

13. The electronic control unit of claim 12,
wherein a rib (11d) with which the sub-hot side (102) of the sub-thermoelectric element (10) is in thermal contact protrudes from the top case (11).

14. The electronic control unit of any one of claim 1 to 13, wherein the control board (6) comprises a micro control unit (61) configured to control operations of the valve (8) and the thermoelectric element (7) in response to signals corresponding to the abnormal state of the cooling jacket (2).

15. A method of controlling the electronic control unit of any one of claim 1 to 14, comprising:
detecting an abnormal state of the cooling jacket (2) or receiving signals from an external device indicating the abnormal state of the cooling jacket (2); and
in response to said detecting or receiving, operating the valve (8) to block a cooling water flow into the cooling jacket (2) and operating the thermoelectric element (7) to cool the cooling jacket (2).

## Amended claims

### Amended claims in accordance with Rule 137(2) EPC.

1. An electronic control unit comprising:
a cooling jacket (2) disposed between a top case (11) and a bottom case (12), and through which cooling water can flow;
at least one board (3, 4, 5) having a semiconductor element (31, 41, 51) mounted thereon, which is in thermal contact with a first surface of the cooling jacket (2);
a control board (6) disposed in a space formed by the top case (11) and the bottom case (12);
a thermoelectric element (7) having a cooling side (71) in thermal contact with the first surface or another surface opposite to the first surface of the cooling jacket (2);
a valve (8) for closing or opening a cooling water inlet (24) and/or a cooling water outlet (25) of the cooling jacket (2); and
a temperature sensor configured to detect a temperature of at least one of the semiconductor element (31, 41, 51), the at least one board (3, 4, 5) and the cooling jacket (2),
wherein, in response to an abnormal state of the cooling jacket (2), the valve (8) is configured to close the cooling water inlet (24) and/or the cooling water outlet (25) and the thermoelectric element (7) is configured to operate to cool the cooling jacket (2),
wherein the abnormal state of the cooling jacket (2) is determined on the basis of the detected temperature, and
wherein the abnormal state of the cooling jacket (2) is when the detected temperature is equal to or higher than a preset temperature.

2. The electronic control unit of claim 1, wherein the temperature sensor is configured to detect the temperature of the semiconductor element (31, 41, 51).

3. The electronic control unit of claim 1 or 2, wherein the at least one board (3, 4, 5) comprises at least one of i) a first board (3) having a first semiconductor element (31) mounted thereon, which is in thermal contact with the opposite surface of the cooling jacket (2); ii) a second board (4) having a first semiconductor element (41) mounted thereon, which is in thermal contact with the opposite surface of the cooling jacket (2); and iii) a third board (5) having a third semiconductor element (51) mounted thereon, which is in thermal contact with the first surface of the cooling jacket (2).

4. The electronic control unit of any one of claims 1 to 3, wherein the control board (6) is disposed in thermal contact with the upper case (11) or the bottom case (12).

5. The electronic control unit of any one of claims 1 to 4, wherein a hot side (72) of the thermoelectric element (7) is in thermal contact with the top case (11), the bottom case (12) or ambient case.

6. The electronic control unit of any one of claims 1 to 5, wherein the valve (8) is configured to close the cooling water inlet (24) of the cooling jacket (2).

7. The electronic control unit of any one of claims 1 to 6, insofar as depending on claim 3, further comprising:
a first thermal interface material (32) disposed between an upper surface of the first semiconductor element (31) and the opposite surface of the cooling jacket (2) in case where the at least one board (3, 4, 5) comprises the first board (3);
a second thermal interface material (42) disposed between an upper surface of the second semiconductor element (41) and the opposite surface of the cooling jacket (2) in case where the at least one board (3, 4, 5) comprises the second board (4); and/or
a third thermal interface material (52) disposed between a lower surface of the third semiconductor element (51) and the first surface of the cooling jacket (2) in case where the at least one board (3, 4, 5) comprises the third board (5).

8. The electronic control unit of any one of claims 1 to 7,
wherein the top case (11) comprises:
a top body (14) having an opening (14a) formed therein; and
a heat dissipation member (15) disposed in the opening (15a) and having heat dissipation fins (15a) formed therein.

9. The electronic control unit of claim 8,
wherein the heat dissipation member (15) is in thermal contact with the hot side (72).

10. The electronic control unit of claim 8 or 9,
wherein the top case (11) further comprises an insulation member (16) disposed between the top body (14) and the heat dissipation member (15).

11. The electronic control unit of claim 10,
wherein the top case (11) further comprises a fastening member (17) that couples the heat dissipation member (15), the insulation member (16), and the top body (14).

12. The electronic control unit of any one of claims 1 to 11, further comprising:
a sub-thermoelectric element (10) having a sub-cooling side (101) in thermal contact with a side of the cooling jacket (2) and a sub-hot side (102) in thermal contact with the top case (11) or the bottom case (12).

13. The electronic control unit of claim 12,
wherein a rib (11d) with which the sub-hot side (102) of the sub-thermoelectric element (10) is in thermal contact protrudes from the top case (11).

14. The electronic control unit of any one of claim 1 to 13, wherein the control board (6) comprises a micro control unit (61) configured to control operations of the valve (8) and the thermoelectric element (7) in response to signals corresponding to the abnormal state of the cooling jacket (2).

15. A method of controlling the electronic control unit of any one of claim 1 to 14, comprising:
detecting an abnormal state of the cooling jacket (2) or receiving signals from an external device indicating the abnormal state of the cooling jacket (2); and
in response to said detecting or receiving, operating the valve (8) to block a cooling water flow into the cooling jacket (2) and operating the thermoelectric element (7) to cool the cooling jacket (2).
